# EUROPEAN PATENT SPECIFICATION

(11) **EP 0 428 146 B1**
(45) Date of publication and mention of the grant of the patent: **10.05.1995**
(21) Application number: 90121737.2
(22) Date of filing: 13.11.1990
(51) Int. Cl.: H01L 31/112

(54) **Field effect transistor type photo-detector**
Photodetektor vom Feldeffekttransistor-Typ
Photodétecteur du type transistor à effet de champ

(30) Priority: 14.11.1989 JP 293927/89
(43) Date of publication of application: 22.05.1991
(73) Proprietor: CANON KABUSHIKI KAISHA, Tokyo (JP)
(72) Inventor: Hiroki, Tamayo, Shimomaruko, Ohta-ku, Tokyo (JP); Nojiri, Hidetoshi, Shimomaruko, Ohta-ku, Tokyo (JP)
(74) Representative: Pellmann, Hans-Bernd, Dipl.-Ing.

(56) References cited:
- US-A- 4 346 394
- APPLIED PHYSICS LETTERS, vol. 51, no. 24, 14th December 1987, pages 2010-1212,New York, NY, US; J.-C. LIOU et al.: "Slow relaxation and electric fieldquenching of persistent conductivity in GaAs metal-semiconductor field-effecttransistors with different buffer layer structures"
- JAPANESE JOURNAL OF APPLIED PHYSICS, vol. 24, no. 5, part 2, May 1985, pagesL367-L369, Tokyo, JP; T. UMEDA et al.: "Effect of incident light illumination
- shape on responsivity of GaAs MESFET photodetector"
- APPLIED PHYSICS LETTERS, vol. 51, no. 26, 28th December 1987, pages 2233-2235,New York, US; C.S. CHANG et al.: "Negative photoconductivity in high electronmobility transistors"

## Description

### Field Effect Transistor Type Photo-Detector

### BACKGROUND OF THE INVENTION

### Field of the Invention

The present invention relates to a photo-detector, and more particularly to a field effect transistor (FET) type photo-detector which is suitable for use in a light integrated circuit.

### Related Background Art

As high speed photo-detectors, a pin photo-diode (pin-PD) and an avalanche photo-diode (APD) have been known. However, the pin-PD has no amplification function. The APD, though it has the amplification function, need a high biasing voltage in operation and hence it is not suitable for an integrated circuit.

High speed FET type photo-detectors which solve the above problems have been proposed by Umeda et al. in Papers of The Institute of Electronics and Communication Engineers of Japan, vol. J68-C, p. 263 (1985) and C. Y. Chen et al. in Appl. Phys. Letter. 41, p. 1040 (1983).

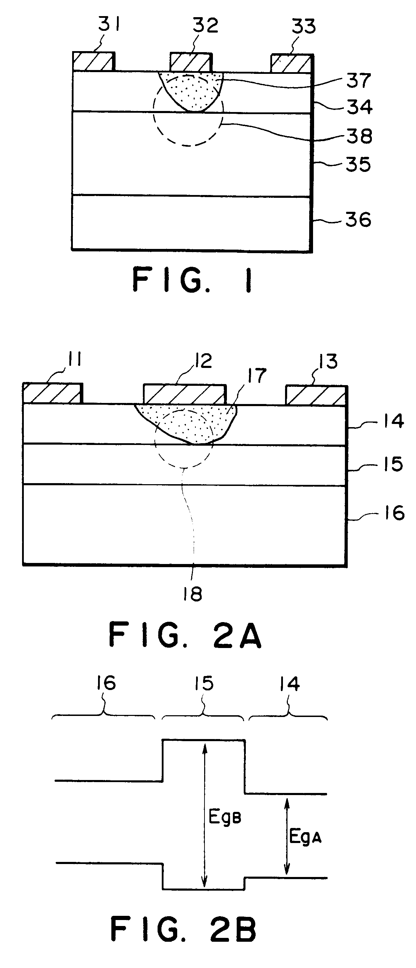

Fig. 1 shows a sectional view of a GaAs-MES-FET type photo-detector. In this photo-detector, a non-doped GaAs buffer layer 35 is laminated on a GaAs semi-insulative substrate 36, and an n type GaAs activation layer 34 having a thickness of 0.2 to 0.5 »m is laminated on the buffer layer 35. A source electrode 31, a gate electrode 32 and a drain electrode 33 for inputting and outputting currents are formed on the activation layer 34. When the photo-detector is biased through the electrodes 31, 32 and 33 and an incident light 38 is applied to the surface or sectional plane, a photo-current flows across the drain electrode 33 and the source electrode 31 so that the incident light 38 can be detected.

Such an FET type photo-detector has advantages of relatively low biasing voltage, built-in amplification function and applicability to a driver or an amplifier of an integrated semiconductor laser (LD).

However, in the photo-detector of the structure shown in Fig. 1, both of the activation layer and the buffer layer are made of GaAs and have the same band gap. Accordingly, when a light having a larger beam diameter than the thickness of the activation layer is irradiated to the end plane of the photo-detector, the light is irradiated to the activation layer as well as the buffer layer so that it is absorbed by the buffer layer, too. In the buffer layer, electron-hole pairs are generated due to the light absorption and the carriers are diffused and reach a depletion layer 37 in the activation layer or are recombined before they reach the depletion layer. As a result, a time response characteristic is deteriorated. Further, the confinement of the carriers in the activation layer which functions as a channel is not sufficient but the carriers leak to the buffer layer and the substrate. As a result, a pinch-off characteristic is deteriorated and an S/N ratio is lowered and a sensitivity is lowered.

### SUMMARY OF THE INVENTION

It is an object of the present invention to provide a high speed and high sensitivity FET type photo-detector which solves the problems encountered in the prior art photo-detector.

The above object of the present invention is achieved by a field effect transistor type photo-detector according to claim 1, the first part of claim 1 being based on Appl. Phys. Lett. **51** (24), 14 December 1987, p.2010-2012.

### BRIEF DESCRIPTION OF THE INVENTION

Fig. 1 shows a sectional view of a prior art FET type photo-detector,
Figs. 2A and 2B show a sectional view and an energy band of an FET type photo-detector outside the scope of the present invention, and
Figs. 3A and 3B show a sectional view and an energy band of an FET type photo-detector of the present invention.

### DETAILED DESCRIPTION OF THE PREFERRED EMBODIMENTS

Figs. 2A and 2B show a sectional view and an energy band of an embodiment of an FET type photo-detector similar to a photo-detector shown in US-A-4346394. The like elements are designated by the like numerals.

In the FET type photo-detector of the present embodiment, a p-Aℓ_{0.3}Ga_{0.7}As buffer layer 15 having a thickness of 0.4 »m is deposited on a semi-insulative GaAs substrate 16, and an n-GaAs activation layer 14 having a thickness of 0.2 »m is deposited thereon. As shown in Fig. 2B, an energy gap Eg_{B} of the buffer layer 15 is wider than an energy gap Eg_{A} of the activation layer 14. The buffer layer 15 has an energy band which acts as a barrier to the carriers. For example, in the present embodiment, since the carriers are primarily electrons, a potential of a conduction band of the buffer layer 15 is selected to be higher than a potential of a conduction band of the activation layer 14. Where the carriers are primarily holes, a potential of a fill band of the buffer layer 15 is selected to be lower than a potential of a fill band of the activation layer 14. AuGe/Au source electrode 11 and drain electrode 13, and an Aℓ gate electrode 12 are formed on the activation layer 14. A gate length is 1 »m, a gate width is 200 »m and a spacing between the respective electrodes is 1 »m.

In the photo-detector of the above construction, when a positive voltage V_{D} is applied to the source electrode 11 and a voltage V_{G} is applied to the gate electrode 12, electrons flow in the activation layer 14 from the source electrode 11 to the drain electrode 13. Since the gate electrode 12 is a Schottky electrode, the depletion layer 17 extends into the activation layer. Since the width of the depletion layer 17 changes with the gate voltage V_{G}, a channel width which provides a path for the electrons in the activation layer 14 changes accordingly. As a result, a drain current I_{D} which flows between the drain electrode 13 and the source electrode 11 changes, and when the depletion layer 17 reaches the buffer layer 15, the channel is closed and the current I_{D} no longer flows. When a light 18 of a semiconductor laser having a wavelength of 830 nm is irradiated to the underside of the gate electrode 12 from the end plane of the device with zero current I_{D}, the width of the depletion layer 17 changes with the irradiation light intensity, and the drain current I_{D} flows between the source electrode 11 and the drain electrode 13 so that the light intensity is detected.

It is now assumed that a beam diameter of the incident light 18 is 1 »m. In this case, since the beam diameter is 1 »m relative to the activation layer thickness of 0.3 »m, a light is irradiated to other area than the activation layer 14. However, since the buffer layer 15 is made of Aℓ_{0.3}Ga_{0.7}As, it does not absorb the light having the wavelength of 830 nm and the time response characteristic is not deteriorated. Further, since the carriers are positively confined by the n-p heterojunction of the n-GaAs activation layer 14 and the p-Aℓ_{0.3}Ga_{0.7}As buffer layer 15, the pinch-off characteristic is good and the photo-current does not leak to the substrate.

Accordingly, in accordance with the present embodiment, the current representing the intensity of the light irradiated to the activation layer 14 is always obtained in a stable manner and the response is fast. Accordingly, a sufficient photo-current characteristic is attained even for a high light irradiation frequency.

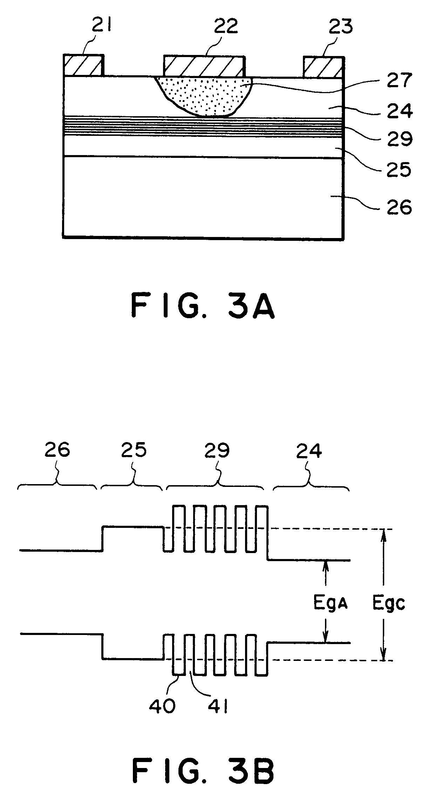

Figs. 3A and 3B show a sectional view and an energy band of an FET type photo-detector of the present invention. The like elements are designated by the like numerals.

In the present embodiment, a buffer layer having a thickness of 0.4 »m and made of i-Aℓ_{0.3}Ga_{0.7}As is formed on a semi-insulative GaAs substrate 26. A GaAs layer having a thickness of 3nm (30 Å) and an Aℓ_{0.5}Ga_{0.5}As layer having a thickness of 6nm (60 Å) are alternately and repeatedly laminated on the buffer layer 25 to form a super lattice buffer layer 29 having a total thickness of 0.45 »m. In Fig. 3B, numeral 40 in the super lattice buffer layer 29 denotes an Aℓ_{0.5}Ga_{0.5}As barrier layer and numeral 41 denotes a GaAs well layer. An n-GaAS activation layer 24 having a thickness of 0.3 »m is deposited on the super lattice buffer layer 29. Au Ge/Au source electrode 21 and drain electrode 23, and an Aℓ gate electrode 22 are formed on the activation layer 24. A gate length is 1 »m, a gate width is 200 »m and a spacing between the respective electrodes is 1 »m.

When the buffer layer is of super lattice structure like in the present embodiment, the band gap may be grasped as a distance between base energy levels created in a conduction band and a fill band by a quantum effect. In the present embodiment, a band width Eg_{C} of a lowest sub-band created by the quantum effect of the super lattice buffer layer 29 is wider than a band gap Eg_{A} of the activation layer 24. Further, a lowest energy level of the conduction band of the super lattice buffer layer 29 is selected to be higher than a potential of the conduction band of the activation layer 24. In this case, the combination of the materials of the super lattice may be that at least one of them is made of a material having a wider band gap than that of the activation layer and others may be made of materials which have equal, larger or smaller band gaps to or than that of the activation layer.

In the photo-detector of the present embodiment, like in the previous embodiment, bias voltages are applied to the electrodes 21, 22 and 23 and the light is irradiated while the depletion layer 27 extends throughout the activation layer 24, that is, under zero drain current I_{D}, and the photo-current is detected. Since the GaAs/Aℓ_{0.5}Ga_{0.5}As super lattice buffer layer 29 is deposited under the activation layer 24, the light irradiated thereto is not essentially absorbed and the response characteristic is not affected. The super lattice buffer layer 29 serves as the barrier to prevent the carriers in the activation layer 24 from leaking into the i-Aℓ_{0.3}Ga_{0.7}As buffer layer 25 or the substrate 26. By providing the super lattice buffer layer 29 in the hetero-interface of the activation layer 24, the condition of the interface is improved and the photo-current characteristic is improved.

## Claims

1. A field effect transistor type photo-detector comprising:
a substrate (26);
a super-lattice structure semiconductor buffer layer (29) having such a band gap (E_{gC}) that it does not absorb light and being arranged on said substrate (26);
a semiconductor activation layer (24) formed on said buffer layer (29), wherein
a lowest energy sub-band of said super-lattice structure semiconductor buffer layer (29) has a wider band width than a band gap (E_{gA}) of said semiconductor activation layer (24), and the lowest energy sub-band of said super-lattice structure semiconductor buffer layer (29) serves as a barrier to carriers; and
a source electrode (21), a drain electrode (23) and a gate electrode (22) arranged on said semiconductor activation layer (24), wherein
a depletion region (27) for controlling a current flowing between said source electrode (21) and said drain electrode (23) is created in said semiconductor activation layer (24) by applying a voltage to said gate electrode (22), and a width of said depletion region (27) changes when light irradiates said semiconductor activation layer (24),
said field effect transistor type photo-detector being **characterized** by
a further buffer layer (25) arranged between said substrate (26) and said super-lattice structure semiconductor buffer layer (29), wherein
said further buffer layer (25) is made of undoped AlGaAs.

2. A field effect transistor type photo-detector according to claim 1, **characterized in that** said semiconductor activation layer (24) is made of n-type GaAs.

3. A field effect transistor type photo-detector according to claim 2, **characterized in that** the thickness of said semiconductor activation layer (24) is 0.3 »m.

4. A field effect transistor type photo-detector according to claim 2, **characterized in that** said super-lattice structure semiconductor buffer layer (29) on said further buffer layer (25) of undoped AlGaAs arranged on said substrate (26) is formed by alternately and repeatedly laminating a GaAs well layer (41) and an AlGaAs barrier layer (40).

5. A field effect transistor type photo-detector according to claim 4, **characterized in that** the thickness of each of said GaAs well layers (41) is 3 nm, the thickness of each of said AlGaAs barrier layers (40) is 6 nm, and the thickness of said super-lattice structure semiconductor buffer layer (29) is 0.45 »m.

6. A field effect transistor type photo-detector according to any of the preceding claims 1 to 5, **character****ized in that** the thickness of said further buffer layer (25) is 0.4 »m.

## Patentansprüche

1. Photodetektor vom Feldeffekttransistor-Typ mit:
einem Substrat (26);
einer auf dem Substrat (26) ausgebildeten Halbleiter-Zwischenschicht (29) mit einer Übergitterstruktur, die eine derartige Bandlücke (E_{gC}) hat, daß sie kein Licht absorbiert;
einer auf der Zwischenschicht (29) ausgebildeten Halbleiter-Aktivierungsschicht (24), wobei
ein niedrigstes Energie-Unterband der Halbleiter-Zwischenschicht (29) mit Übergitterstruktur eine größere Bandweite als eine Bandlücke (E_{gA}) der Halbleiter-Aktivierungsschicht (24) hat, und das niedrigste EnergieUnterband der Halbleiter-Zwischenschicht (29) mit Übergitterstruktur als Barriere für Ladungsträger dient; und
einer Source-Elektrode (21), einer Drain-Elektrode (23) und einer Gate-Elektrode (22), die auf der Halbleiter-Aktivierungsschicht (24) angeordnet sind, wobei in der Halbleiter-Aktivierungsschicht (24) ein Verarmungsbereich (27) zum Steuern eines zwischen der Source-Elektrode (21) und der Drain-Elektrode (23) fließenden Stromes durch Anlegen einer Spannung an die Gate-Elektrode (22) erzeugt wird, und eine Weite des Verarmungsbereiches (27) sich ändert, wenn Licht auf die Halbleiter-Aktivierungsschicht (24) auftrifft,
**gekennzeichnet durch**
eine weitere Zwischenschicht (25), die zwischen dem Substrat (26) und der Halbleiter-Zwischenschicht (29) mit Übergitterstruktur ausgebildet ist, wobei
die weitere Zwischenschicht (25) aus undotiertem Al-GaAs besteht.

2. Photodetektor vom Feldeffekttransistor-Typ nach Anspruch 1,
**dadurch gekennzeichnet, daß**
die Halbleiter-Aktivierungsschicht (24) aus n-Typ GaAs besteht.

3. Photodetektor vom Feldeffekttransistor-Typ nach Anspruch 2,
**dadurch gekennzeichnet, daß**
die Dicke der Halbleiter-Aktivierungsschicht (24) 0.3 »m beträgt.

4. Photodetektor vom Feldeffekttransistor-Typ nach Anspruch 2,
**dadurch gekennzeichnet, daß**
die Halbleiter-Zwischenschicht (29) mit Übergitterstruktur auf der auf dem Substrat (26) ausgebildeten weiteren Zwischenschicht (25) aus undotiertem AlGaAs durch abwechselndes und wiederholtes Laminieren einer GaAs-Wannenschicht (41) und einer AlGaAs-Barrierenschicht (40) ausgebildet wird.

5. Photodetektor vom Feldeffekttransistor-Typ nach Anspruch 4,
**dadurch gekennzeichnet, daß**
die Dicke jeder der GaAs-Wannenschichten (41) 3 nm beträgt, die Dicke jeder der AlGaAs-Barrierenschichten (40) 6 nm beträgt, und die Dicke der Halbleiter-Zwischenschicht (29) mit Übergitterstruktur 0.45 »m beträgt.

6. Photodetektor vom Feldeffekttransistor-Typ nach einem der vorhergehenden Ansprüche 1 bis 5,
**dadurch gekennzeichnet, daß**
die Dicke der weiteren Zwischenschicht (25) 0.4 »m beträgt.

## Revendications

1. Photodétecteur du type à transistor à effet de champ comprenant:
un substrat (26);
une couche (29) tampon semiconductrice à structure de super-réseau ayant une largeur de bande interdite (EgC) qui n'absorbe pas de lumière et agencée sur ledit substrat (26);
une couche (24) d'activation semiconductrice formée sur ladite couche tampon (29), dans lequel
une sous-bande d'énergie la plus faible de ladite couche (29) tampon semiconductrice à structure de super-réseau présente une largeur de bande supérieure à celle d'une bande interdite (E_{gA}) de ladite couche (24) d'activation semiconductrice, et la sous-bande d'énergie la plus faible de ladite couche (29) tampon semiconductrice à structure de super-réseau joue le rôle de couche d'arrêt vis-à-vis des porteurs; et
une électrode (21) de source, une électrode (23) de drain et une électrode (22) de grille disposées sur ladite couche (24) d'activation semiconductrice, dans lequel
une région (27) de déplétion destinée à commander le courant passant entre ladite électrode (21) de source et ladite électrode (23) de drain est créée dans ladite couche (24) d'activation semiconductrice par application d'une tension à ladite électrode (22) de grille, et la largeur de ladite région (27) de déplétion varie lorsqu'une lumière irradie ladite couche (24) d'activation semiconductrice,
ledit photodétecteur dudit type à transistor à effet de champ étant caractérisé par:
une autre couche (25) tampon disposée entre ledit substrat (26) et ladite couche (29) tampon semiconductrice à structure de super-réseau,
ladite autre couche (25) tampon étant constituée d'AlGaAs non dopé.

2. Photodétecteur du type transistor à effet de champ selon la revendication 1, caractérisé en ce que ladite couche (24) d'activation semiconductrice est constituée de GaAs de type n.

3. Photodétecteur du type transistor à effet de champ selon la revendication 2, caractérisé en ce que l'épaisseur de ladite couche (24) d'activation semiconductrice est de 0,3 »m.

4. Photodétecteur du type transistor à effet de champ selon la revendication 2, caractérisé en ce que ladite couche (29) tampon semiconductrice à structure de super-réseau se trouvant sur ladite autre couche (25) tampon d'AlGaAs non dopé disposée sur ledit substrat (26), est formée par stratification alternée et répétée d'une couche (41) formant puits de GaAs et d'une couche (40) d'arrêt d'AlGaAs.

5. Photodétecteur du type transistor à effet de champ selon la revendication 4, caractérisé en ce que l'épaisseur de chacune des couches (41) formant puits de GaAs est de 3 nm, en ce que l'épaisseur de chacune desdites couches (40) d'arrêt d'AlGaAs est de 6 nm, et en ce que l'épaisseur de ladite couche (29) tampon semiconductrice à structure de super-réseau est de 0,45 »m.

6. Photodétecteur du type transistor à effet de champ selon l'une quelconque des revendications 1 à 5 précédentes, caractérisé en ce que l'épaisseur de ladite autre couche (25) tampon est de 0,4 »m.
